Europäisches Patentamt

European Patent Office

Office européen des brevets

(19)

(11) Veröffentlichungsnummer: **0 065 135**
**B1**

(12) **EUROPÄISCHE PATENTSCHRIFT**

(45) Veröffentlichungstag der Patentschrift:
27.03.85

(51) Int. Cl.⁴: **H 03 K 17/04, H 02 M 3/155**

(21) Anmeldenummer: 82103578.9

(22) Anmeldetag: 27.04.82

(54) Ansteuerschaltung für pulsgesteuerte Schalttransistoren.

(30) Priorität: 08.05.81 DE 3118334

(43) Veröffentlichungstag der Anmeldung:
24.11.82 Patentblatt 82/47

(45) Bekanntmachung des Hinweises auf die Patenterteilung:
27.03.85 Patentblatt 85/13

(84) Benannte Vertragsstaaten:
AT BE CH DE FR GB LI NL

(56) Entgegenhaltungen:
EP - A - 0 019 471
US - A - 3 657 569
US - A - 3 820 008
US - A - 4 164 667

(73) Patentinhaber: Siemens Aktiengesellschaft, Berlin und München Wittelsbacherplatz 2, D-8000 München 2 (DE)

(72) Erfinder: Segger, Bernd, Isarstrasse 4, D-8520 Erlangen (DE)

# Beschreibung

Die Erfindung betrifft eine Ansteuerschaltung für pulsgesteuerte Schalttransistoren mit einem Übertrager mit einer Primärwicklung im Kollektor-Emitter-Kreis des Schalttransistors sowie mit einer ersten Sekundärwicklung, die in Reihenschaltung mit einem Ansteuertransistor zwischen einer über die Primärwicklung mit dem Kollektor des Schalttransistors verbundenen Eingangsspannungsklemme und der Basis des Schalttransistors liegt und die von einer ersten Diode überbrückt ist und mit einer zweiten Sekundärwicklung, die in Reihenschaltung mit einer zweiten Diode parallel zur Basis-Emitter-Strecke des Schalttransistors liegt.

Eine derartige Ansteuerschaltung ist aus der US-PS 4 164 667 bekannt. Dabei wird mit der ersten Sekundärwicklung der Spannungsabfall am Ansteuertransistor und an der Basis-Emitter-Strecke des Schalttransistors kompensiert. Damit erhält man auch bei niedriger Kollektor-Emitter-Spannung des Schalttransistors noch einen ausreichenden Steuerstrom. Beim Einschaltvorgang wird zunächst der Ansteuertransistor eingeschaltet, wobei der Strom durch den Schalttransistor aufgrund dessen Schaltverzögerung zunächst nur langsam ansteigt. Dieser Strom wird über den Übertrager mit den beiden in Serie geschalteten Sekundärwicklungen in den Basis-Emitter-Kreis des Schalttransistors übertragen. Die Spannungen der beiden Sekundärwicklungen sind entgegengesetzt gepolt, so daß die Differenz der entsprechenden Windungszahlen wirksam wird. Die resultierende, an den beiden Sekundärwicklungen anstehende Spannung liegt für den Schalttransistor in Sperrrichtung, so daß dieser zunächst noch nicht voll eingeschaltet werden kann. Die zweite Sekundärwicklung dient also dazu, den Schalttransistor negativ vorzupolen. In einer ersten Phase des Einschaltvorgangs ist also der Ansteuertransistor leitend, während der Schalttransistor noch gesperrt bleibt. Während dieser Phase geht der Übertrager in die negative Sättigung. Damit wird die über die Reihenschaltung der beiden Sekundärwicklungen zurückgekoppelte Spannung geringer und die Basis-Emitter-Spannung des Schalttransistors wird negativ. Der Übertrager geht dabei von der negativen in die positive Sättigung und durchläuft dabei einen ungesättigten Bereich. Die dabei an der Reihenschaltung der beiden Sekundärwicklungen anstehende Spannung kompensiert den Spannungsabfall an der Basis-Emitter-Strecke des Schalttransistors sowie am Ansteuertransistor. Der Schalttransistor wird durch eine negative Basisspannung am Ansteuertransistor ausgeschaltet, wobei der Fluß im Übertrager wieder zurückgesetzt wird.

Bei dieser bekannten Anordnung erfolgt also eine Rückkopplung aus dem Kollektor-Emitter-Kreis des Schalttransistors in dessen Basis-Kreis stets über die Reihenschaltung zweier Sekundärwicklungen, wobei die Differenz der beiden Windungszahlen wirksam wird. Bei dieser Anordnung wird der Einschaltvorgang bis zur Sättigung des Übertragers zunächst verzögert und erst dann durch die rückgekoppelte Spannung unterstützt.

Aus der DE-AS 2 354 104 ist eine Ansteuerschaltung für pulsgesteuerte Schalttransistoren mit einem Übertrager mit einer Primärwicklung im Kollektor-Emitter-Kreis des Schalttransistors bekannt. Der Übertrager weist zwei Sekundärwicklungen auf, wobei die erste Sekundärwicklung in Reihenschaltung mit einem Ansteuertransistor zwischen Basis und Emitter des Schalttransistors liegt. Damit wird eine Rückkopplung des Emitter-Stroms des Schalttransistors in den Basis-Kreis erreicht, die beim Einschalten des Schalttransistors eine Erhöhung der Basisstroms ergibt. Damit kann die Ansteuerleistung des Schalttransistors verringert werden. Zum schnellen Ausräumen der Basis des Schalttransistors kann bei der bekannten Schaltung eine Diode angeordnet sein, die das Sperrpotential von der Basis des Ansteuertransistors an die Basis des Schalttransistors weiterleitet. Außerdem ist eine weitere Diode vorgesehen, die die gespeicherte Energie des Übertragers bei der Abmagnetisierung als Sperrstrom an die Basis des Schalttransistors gibt. Mit einer zweiten Sekundärwicklung des Übertragers wird der Kollektorstrom des Schalttransistors erfaßt und einem Hilfstransistor zugeführt, der bei Überstrom den Schalttransistor ausschaltet. Über den Hilfstransistor und die zweite Sekundärwicklung fließt ein Sperrstrom aus der Basis des Schalttransistors, der diese schnell ausräumt. Dieser Effekt kann auch zur schnellen Ausräumung der Basisladung des Schalttransistors bei jeder normalen Sperr-Ansteuerung ausgenützt werden.

Diese bekannte Schaltung läßt sich jedoch nur dann anwenden, wenn bei NPN-Transistoren der Emitter bzw. bei PNP-Transistoren der Kollektor des Schalttransistors auf Bezugspotential liegt. Dies ist jedoch nicht immer der Fall. Beispielsweise bei getakteten Netzgeräten mit einem NPN-Transistor als Schalttransistor ist der Kollektor des Schalttransistors im allgemeinen mit dem dem Bezugspotential abgewandten Anschluß für die Eingangsspannung und der Emitter — gegebenenfalls über ein Glättungsfilter — mit einer Ausgangsklemme verbunden, da in der das Bezugspotential führenden Leitung z. B. aus Funkentstörgründen kein schaltendes Element liegen soll.

Ferner ist aus der EP-A1-0 019 471 eine Ansteuerschaltung für Schalttransistoren bekannt, bei welcher der Einschaltvorgang eines Transistors durch Mitkopplung über eine zugeordnete erste und der Ausschaltvorgang über eine zugeordnete zweite Sekundärwicklung unterstützt wird.

Aufgabe der Erfindung ist es, eine Ansteuerschaltung der eingangs genannten Art so auszubilden, daß sowohl der Einschalt- als auch der Ausschaltvorgang durch Mit- bzw. Gegenkopplung unterstützt wird, wobei Kollektor und Emitter des Schalttransistors auf beliebiges Potential bezogen sein können.

Diese Aufgabe wird erfindungsgemäß dadurch gelöst, daß in Reihe zur ersten Diode eine entgegengesetzt gepolte erste Z-Diode angeordnet ist, daß in Reihe zur zweiten Diode eine entgegengesetzt gepolte zweite Z-Diode angeordnet ist und daß die erste Sekundärwicklung so gepolt ist, daß der in ihr während eines Einschaltvorgangs induzierte Strom in Richtung eines Einschaltstroms liegt und daß die zweite Sekundärwicklung so gepolt ist, daß der in ihr während eines Ausschaltvorgangs induzierte Strom in Richtung eines Ausschaltstroms liegt.

Bei dieser Ansteuerschaltung kann der Schalttransistor unabhängig von seinem Kollektorbzw. Emitter-Potential durch den Ansteuertransistor ein- und ausgeschaltet werden. Dabei erfolgt über die erste Sekundärwicklung beim Einschaltvorgang eine Rückkopplung des Kollektor-Emitter-Stroms des Schalttransistors in den Basis-Kreis, die so gerichtet ist, daß der Einschaltvorgang unterstützt wird. Die zweite Sekundärwicklung ist dabei durch die Reihenschaltung von zweiter Diode und entgegengesetzt gepolter zweiter Z-Diode abgekoppelt. Beim Ausschaltvorgang erfolgt eine Gegenkopplung über die zweite Sekundärwicklung, die zur Unterstützung des Ausschaltvorgangs beiträgt. Dabei ist die erste Sekundärwicklung wegen des ausgeschalteten Ansteuertransistors abgekoppelt. Bei dieser Anordnung wirken also die beiden Sekundärwicklungen unabhängig voneinander für den Einschalt- bzw. Ausschaltvorgang und können daher in ihren Windungszahlen für die entsprechende Aufgabe optimiert werden. Die Schalttransistor kann unabhängig von seinem Kollektor- bzw. Emitter-Potential durch den Ansteuertransistor ein- und ausgeschaltet werden, wobei zum Ausschalten kein gesonderter Ansteuertransistor erforderlich ist.

Vorteilhafterweise kann die Basis-Emitter-Strecke des Schalttransistors mit der Reihenschaltung einer Z-Diode und einer entgegengesetzt gepolten Diode überbrückt sein. Diese Reihenschaltung übernimmt den Entmagnetisierungsstrom des Übertragers in einer Richtung und schützt die Basis-Emitter-Strecke des Schalttransistors gegen zu hohe Spannungen in Sperrichtung.

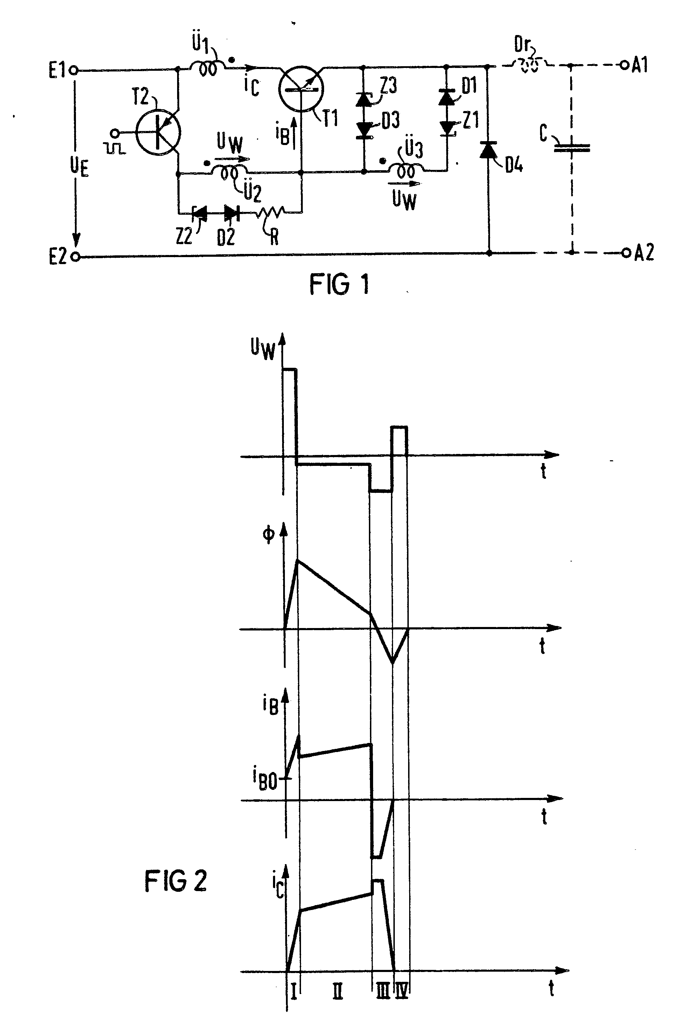

Ein Ausführungsbeispiel der Erfindung wird nachfolgend anhand der Fig. 1 und 2 näher erläutert.

Fig. 1 zeigt ein Ausführungsbeispiel einer Ansteuerschaltung für einen Schalttransistor T1, der in einem getakteten Netzgerät eingesetzt und in diesem Fall ein NPN-Transistor ist. Zwischen einer Eingangsklemme E1, an der eine positive Eingangsspannung $U_E$ ansteht, und einer Ausgangsklemme A1 liegt die Reihenschaltung der Primärwicklung Ü1 eines Übertragers Ü, der Kollektor-Emitter-Strecke eines Schalttransistors T1 und einer Drossel Dr. Die Eingangsklemme E2, an der das Bezugspotential der Schaltungsanordnung ansteht, ist unmittelbar mit der Ausgangsklemme A2 verbunden. Zwischen Eingangsklemme E1 und Basis des Schalttransistors T1 liegt die Reihenschaltung eines PNP-Ansteuertransistors T2 und der ersten Sekundärwicklung Ü2 des Übertragers Ü. Der ersten Sekundärwicklung Ü2 ist die Reihenschaltung einer Z-Diode Z2, einer Diode D2 und eines Widerstands R parallel geschaltet. Dabei ist die Kathode der Z-Diode Z2 dem Kollektor des Ansteuertransistors T2 zugewandt und die Diode D2 ist entgegengesetzt zur Z-Diode Z2 gepolt. Zwischen Basis und Emitter des Schalttransistors T1 liegt die Reihenschaltung einer zweiten Sekundärwicklung Ü3 des Übertragers Ü, einer Z-Diode Z1 und einer Diode D1. Dabei ist die Kathode der Diode D1 dem Emitter des Schalttransistors T1 zugewandt und die Z-Diode Z1 ist entgegengesetzt zur Diode D1 gepolt. Parallel zur Basis-Emitter-Strecke des Schalttransistors T1 liegt außerdem die Reihenschaltung einer weiteren Diode D3 und einer weiteren Z-Diode Z3, deren Kathode dem Emitter des Schalttransistors T1 zugewandt ist. Die Diode D3 ist entgegengesetzt zur Z-Diode Z3 gepolt. Zwischen der Eingangsklemme E2 und dem Verbindungspunkt von Emitter des Schalttransistors T1 und Drossel Dr ist eine Freilaufdiode D4 angeordnet und den Ausgangsklemmen A1, A2 ist ein Glättungskondensator C parallel geschaltet.

Die Windungszahlen der Übertragungswicklungen Ü1 bis Ü3 werden in Abhängigkeit von den Daten des Schalttransistors T1 gewählt. Dabei entspricht das Windungszahlenverhältnis der Primärwicklung Ü1 zur ersten Sekundärwicklung Ü2 der Stromverstärkung des Schalttransistors T1 und das Windungszahlenverhältnis der ersten Sekundärwicklung Ü2 zur zweiten Sekundärwicklung Ü3 entspricht dem optimalen Verhältnis von Einschaltstrom zu Ausräumstrom. Da Einschaltstrom und Ausräumstrom im allgemeinen gleich sein sollten, werden auch die Windungszahlen von erster und zweiter Sekundärwicklung Ü1, Ü2 gleich gewählt.

Die Funktion der Ansteuerschaltung nach Fig. 1 wird im folgenden anhand der Diagramme von Fig. 2 erläutert. In Fig. 2 ist der zeitliche Verlauf der Spannung $U_W$ an der ersten Sekundärwicklung Ü2, des Flusses $\emptyset$ im Übertrager Ü, des Basisstroms $i_B$ in die Basis des Schalttransistors T1 und den Kollektorstroms $i_C$ des Schalttransistors T1 dargestellt. Es wird davon ausgegangen, daß die Windungszahlen der beiden Sekundärwicklungen Ü2 und Ü3 gleich sind, so daß an der zweiten Sekundärwicklung Ü3 wie an der ersten Sekundärwicklung Ü2 die Spannung $U_W$ ansteht.

Zum Einschalten des Schalttransistors T1 wird an die Basis des Ansteuertransistors T2 ein gegenüber dessen Emitter negativer Impuls gelegt, so daß dieser einschaltet. Während des Einschaltvorgangs, der in Fig. 2 mit I gekennzeichnet ist, ist die Freilaufdiode D4 noch leitend. Damit steht an der ersten Sekundärwicklung Ü2 des Übertragers Ü sowie an der Reihenschaltung von Z-Diode Z2, Diode D2 und Widerstand R nahezu die volle Eingangsspannung $U_E$ an. Dabei ist anzumerken, daß die Ansteuerschaltung auch dann funktioniert, wenn keine Freilaufdiode D4 vorhanden ist. Es muß lediglich beim Einschalten eine Spannung zwischen Kollektor und Emitter des Schalttransistors T1 anstehen. Diese Spannung treibt über die in diesem Fall leitende Z-Diode Z2, die Diode D2 und den Widerstand R einen Basisstrom $i_{BO}$, der den Schalttransistor T1 leitend werden läßt. Der damit einsetzende Kollektorstrom $i_C$ durchfließt die Primärwicklung Ü1 und wird auf die Sekundärwicklung Ü2 transformiert. Die Sekundärwicklung Ü2 ist so gepolt, daß der Strom durch die Sekundärwicklung Ü2 sich zum Strom $i_{BO}$ durch den Widerstand R addiert, so daß der Basisstrom $i_B$ schnell ansteigt und der Schalttransistor T1 in kurzer Zeit und damit verlustarm völlig durchschaltet. Die zweite Sekundärwicklung Ü3 ist so gepolt, daß für die Diode D1 die in der zweiten Sekundärwicklung Ü3 induzierte Spannung $U_W$ in Sperrichtung liegt, so daß in der Phase I kein Stromfluß über die zweite Sekundärwicklung Ü3 möglich ist.

Mit dem Leitendwerden des Schalttransistors kommutiert der Strom durch die Drossel Dr von der Freilaufdiode D4 auf den Schalttransistor T1 und die Freilaufdiode D4 wird stromlos. Damit springt die Spannung am Emitter des Schalttransistors T1 nahezu auf die Eingangsspannung $U_E$. In der nun folgenden Phase II wird der Basisstrom $i_B$ des Schalttransistors T1 durch die ersten Sekundärwicklung Ü2 des Übertragers Ü aufgebracht. Die Spannung $U_W$ an den beiden Sekundärwicklungen Ü2 und Ü3 wird leicht negativ und der Fluß $\emptyset$ durch den Übertrager Ü nimmt ab. Da der Anteil des Basisstroms über den Widerstand R wegen der mit der Spannungsumkehr sperrenden Diode D2 entfällt, nimmt der Basisstrom $i_B$ sprungartig ab und steigt dann, allerdings mit geringerer Steigung als in der Phase I, wieder an. Der Kollektorstrom $i_C$ steigt ebenfalls an, jedoch flacher als in der Phase I. Die in der Wicklung Ü3 induzierte kleine negative Spannung $U_W$, die für die Diode D1 in Leitrichtung liegt, wird in der Phase II von der Z-Diode Z1 aufgenommen, so daß die zweite Sekundärwicklung Ü3 stromlos bleibt.

Um den Schalttransistor T1 auszuschalten wird der Ansteuertransistor T2 gesperrt. Der durch den Übertrager Ü transformierte Kollektorstrom $i_C$ kann damit nicht mehr über den Ansteuertransistor T2 und die erste Sekundärwicklung Ü2 in die Basis des Schalttransistors T1 fließen. Auch der Weg über die Z-Diode Z2 und den Widerstand R ist durch die Diode D2 blockiert. Dieser Strom kommutiert daher auf die zweiten Sekundärwicklung Ü3, wobei die Spannung $U_W$ soweit ansteigt, daß die Z-Diode Z1 leitend wird. Der Basisstrom $i_B$ wird damit negativ und bewirkt ein Ausräumen der Basiszone des Schalttransistors T1. Sobald der Kollektorstrom $i_C$ Null geworden ist, verschwindet auch der Basisstrom $i_B$.

In der nun folgenden Phase IV wird der Übertrager Ü1 entmagnetisiert. Wenn der Fluß $\emptyset$ beim Ausschaltvorgang negativ geworden ist, wie dies in Fig. 2 dargestellt ist, so erfolgt die Entmagnetisierung über die Z-Diode Z2, die Diode D2 und den Widerstand R. Ist dagegen der Fluß $\emptyset$ positiv geblieben, z. B. weil die Leitphase II sehr kurz war, so erfolgt die Entmagnetisierung über die Z-Diode Z3, die Diode D3, die Z-Diode Z1 und die Diode D1. Mit der Z-Diode Z3 und der Diode D3 wird die Basis-Emitter-Strecke des Schalttransistors T1 vor einer Überlastung in Sperrichtung geschützt.

Als Sonderfall ist zu betrachten, daß der Schalttransistor T1 über längere Zeit eingeschaltet bleibt, also bei einem Tastverhältnis von 1 oder nahe 1 betrieben wird. In diesem Fall geht der Übertrager Ü in Sättigung, so daß keine Transformation des Kollektorstroms $i_C$ in die Sekundärwicklung Ü2 erfolgt. Durch die dann eintretende Abnahme des Basisstroms $i_B$ erhöht sich jedoch die Kollektor-Emitter-Spannung des Transistors T1 so weit, daß der von der Eingangsklemme E1 über den Ansteuertransistor T2 und die Sekundärwicklung Ü2 fließende Basisstrom ausreicht, den Schalttransistor T1 bei etwas erhöhter Kollektor-Emitter-Spannung leitend zu halten. Beim Ausschalten des Schalttransistors T1 bleibt die Gegenkopplung über den Übertrager Ü erhalten, da die Magnetisierungskennlinie des Übertragers Ü auch im gesättigten Zustand noch eine gewisse Steigung aufweist.

## Patentansprüche

1. Ansteuerschaltung für pulsgesteuerte Schalttransistoren mit einem Übertrager mit einer Primärwicklung (Ü1) im Kollektor-Emitter-Kreis des Schalttransistors (T1) sowie mit einer ersten Sekundärwicklung (Ü2), die in Reihenschaltung mit einem Ansteuertransistor (T2) zwischen einer über die Primärwicklung mit dem Kollektor des Schalttransistors verbundenen Eingangsspannungsklemme (E1) und der Basis des Schalttransistors liegt und die von einer ersten Diode (D2) überbrückt ist und mit einer zweiten Sekundärwicklung (Ü3), die in Reihenschaltung mit einer zweiten Diode (D1) parallel zur Basis-Emitter-Strecke des Schalttransistors liegt, dadurch gekennzeichnet, daß in Reihe zur ersten Diode (D2) eine entgegengesetzt gepolte erste Z-Diode (Z2) angeordnet ist, daß in Reihe zur zweiten Diode (D1) eine entgegengesetzt gepolte zweite Z-Diode (Z1) angeordnet ist und daß die ersten Sekundärwicklung (Ü2) so gepolt ist, daß der in ihr während eines Einschaltvorgangs induzierte Strom in Richtung eines Einschaltstroms liegt und daß die zweite Sekundärwicklung (Ü3) so gepolt ist, daß der in ihr während eines Ausschaltvorgangs induzierte Strom in Richtung eines Ausschaltstroms liegt.

2. Ansteuerschaltung nach Anspruch 1, dadurch gekennzeichnet, daß die Basis-Emitter-Strecke des Schalttransistors (T1) mit der Reihenschaltung einer Z-Diode (Z3) und einer entgegengesetzt gepolten Diode (D3) überbrückt ist.

## Claims

1. A drive circuit for pulse controlled switching transistors, with a transformer having a primary winding (Ü1) in the collector-emitter path of the switching transistor (T1), and having a first secondary winding (Ü2) arranged in series with a drive transistor (T2) between an input voltage terminal (E1) — which is connected via the primary winding to the collector of the switching transistor — and the base of the switching transistor, and is bridged by a first diode (D2), and having a second diode (D1) parallel to the base-emitter path of the switching transistor, characterised in that the first diode (D2) is arranged in series with an oppositely poled first Z-diode (Z2), that the second diode (D1) is arranged in series with an oppositely poled second Z-diode (Z1), and that the first secondary winding (Ü2) is poled in such manner that the current induced within it during a switch-on procedure is in the direction of a switch-on current, and that the second secondary winding (Ü3) is poled in such manner that the current induced within it during an switch-off procedure is in the direction of a switch-off current.

2. A drive circuit as claimed in claim 1, characterised in that the base-emitter path of the switching transistor (T1) is bridged by the series combination of a Z-diode (Z3) and an oppositely poled diode (D3).

## Revendications

1. Circuit d'attaque pour des transistors de commutation commandés par impulsions, comportant un transformateur avec un enroulement primaire (Ü1) dans le circuit collecteur-émetteur du transistor de commutation (T1), ainsi qu'avec un premier enroulement secondaire (Ü2) qui est situé, en circuit série avec un transistor d'attaque (T2), entre une borne de tension d'entrée (E1) reliée au collecteur du transistor de commutation par l'intermédiaire de l'enroulement primaire, et la base du transistor de commutation, et qui est shunté par une première diode (D2), et comportant un second enroulement secondaire (Ü3) qui, relié en série avec une seconde diode (D1), est monté en parallèle sur le circuit base-émetteur du transistor de commutation, caractérisé par le fait qu'en série avec la première diode (D2) est disposée une première diode Zener (Z2) montée avec une polarité inverse, qu'en série avec la seconde diode (D1) est disposée une seconde diode Zener (Z1) montée avec une polarité inverse, et que le premier enroulement secondaire (Ü2) est monté avec une polarité telle que le courant qui est induit pendant un processus de fermeture est dans le sens du courant de fermeture, et que le second enroulement secondaire (Ü3) est monté avec une polarité telle que le courant qui y est induit pendant un processus d'ouverture est dans le sens du courant d'ouverture.

2. Circuit d'attaque selon la revendication 1, caractérisé par le fait que le circuit base-émetteur du transistor de commutation (T1) est shunté par un circuit série constitué d'une diode Zener (Z3) et par une diode (D3) montée avec une polarité inverse.

FIG 1

FIG 2